# FASCICULE DE BREVET EUROPEEN

(11) **EP 1 690 297 B1**
(45) Date de publication et mention de la délivrance du brevet: **06.03.2013**
(21) Numéro de dépôt: 04805767.3
(22) Date de dépôt: 21.10.2004
(51) Int. Cl.: H01L 29/423, H01L 29/78, H01L 29/66, H01L 29/786

(54) **DISPOSITIF MICROELECTRONIQUE A EFFET DE CHAMP APTE A FORMER UN OU PLUSIEURS CANAUX DE TRANSISTORS**
MIKROELEKTRONISCHE FELDEFFEKTEINRICHTUNG MIT DER FÄHIGKEIT ZUR BILDUNG EINES ODER MEHRERER TRANSISTORKANÄLE
FIELD-EFFECT MICROELECTRONIC DEVICE, CAPABLE OF FORMING ONE OR SEVERAL TRANSISTOR CHANNELS

(30) Priorité: 22.10.2003 FR 0350716
(43) Date de publication de la demande: 16.08.2006
(73) Titulaire: Commissariat à l'Énergie Atomique et aux Énergies Alternatives, 75015 Paris (FR)
(72) Inventeur: ERNST, Thomas, F-38140 CHARNECLES (FR); BOREL, Stephan, F-38400 SAINT MARTIN D'HERES (FR)
(74) Mandataire: Poulin, Gérard
(86) Numéro de dépôt international: PCT/FR2004/050524
(87) Numéro de publication internationale: WO 2005/041309

(56) Documents cités:
- US-A- 5 675 164
- US-A- 5 780 911
- US-A- 5 965 914
- US-A- 6 127 702
- US-A1- 2002 179 970
- US-B1- 6 413 802
- US-B1- 6 475 890
- US-B1- 6 562 665

## Description

### DOMAINE TECHNIQUE ET ART ANTERIEUR

La présente invention se rapporte au domaine des circuits intégrés, et plus particulièrement à celui des transistors à effet de champ.

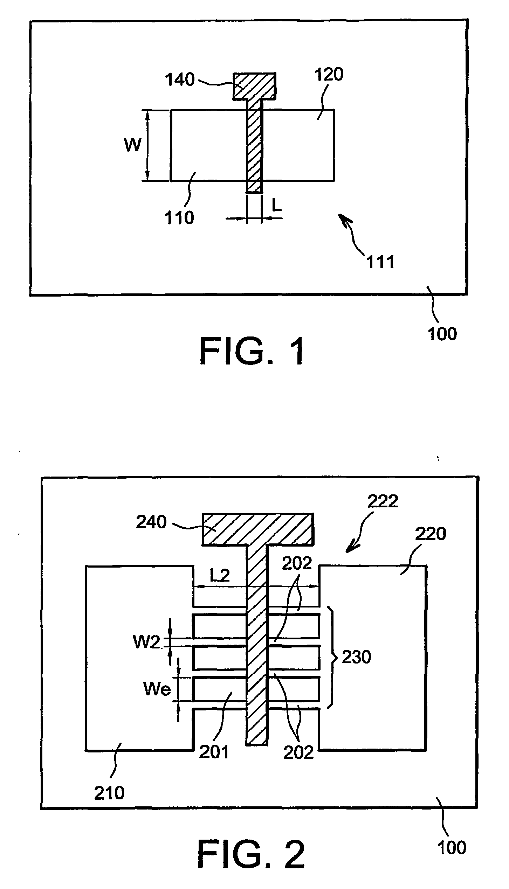

Une structure connue de transistor à effet de champ 111, est illustrée sur la figure 1. Elle comprend une première zone formant une source 110, une seconde zone formant un drain 120 et repose sur un substrat 100 par exemple à base de silicium.

La source 110 et le drain 120 ont une forme sensiblement rectangulaire et affleurent partiellement à la surface du substrat 100. La structure de transistor 111, comporte également un canal sous forme d'un bloc ou barreau, de forme se rapprochant de celle d'un parallélépipède, et permettant de relier dans le sens de sa longueur, la source 110 et le drain 120. Le canal a une longueur notée L mesurée dans une direction source-drain ainsi qu'une largeur notée W mesurée dans une direction parallèle à un plan principal du substrat 100.

Le canal est recouvert d'une zone formant une grille 140. La grille 140 est en contact avec le canal sur une surface S₁ (non représentée sur la figure 1). La grille permet de contrôler la conduction du canal et donc l'intensité d'un courant transitant entre la source 110 et le drain 120.

On cherche continuellement à augmenter les performances des transistors en essayant d'améliorer deux facteurs normalement incompatibles: la vitesse de fonctionnement et la consommation des transistors.

Pour augmenter la vitesse de fonctionnement, on essaie notamment de réduire la taille des transistors, ce qui permet par ailleurs de réduire les coûts de fabrication et de réaliser des circuits intégrés avec un nombre de transistors plus élevé.

Diminuer la taille des transistors implique par exemple le rapprochement de la source et du drain et la réalisation d'un canal de longueur et de largeur de plus en plus faibles. Cette tendance peut entraîner des effets néfastes au bon fonctionnement des transistors tels que des « effets de canal court » (en anglais « short channel effect »). Ainsi, à mesure que l'on diminue la longueur du canal des transistors, le drain et la source ont une influence de plus en plus importante sur la conduction du canal, normalement contrôlée par la grille. Les « effets de canal court » entraînent, entre autres, une diminution de la tension seuil avec la longueur de canal et la tension de drain, ce qui entraîne une augmentation de la fuite du transistor à l'état bloqué. Ceci n'est guère compatible avec l'amélioration des performances des circuits intégrés.

Un second exemple de structure de transistor à effet de champ 222 est illustré sur la figure 2 et présenté dans le document [1] référencé à la fin de la présente description. Cette structure permet de remédier en partie au problème exposé ci-dessus, et notamment de s'affranchir des effets de canal court.

La structure de transistor 222 est formée sur un substrat 100. Elle comprend une première zone rectangulaire formant une source 210 et une seconde zone rectangulaire formant un drain 220 reposant sur le substrat 100. Elle comporte également un canal 230 sous forme de plusieurs barreaux 202 parallélépipédiques juxtaposés sur le substrat 100 et parallèles entre eux. Les barreaux 202 ont des longueurs L₂ et des largeurs W₂. Ils relient, dans le sens de leurs longueurs L₂, la source 210 et le drain 220.

Les barreaux 200 sont séparés entre eux par des espaces 201 de largeur Wₑ. Le canal 230 est recouvert et en contact sur une surface S₂ (non représentée sur la figure 2) avec une grille 240. L'étendue de la surface S₂ influe sur la valeur de la tension de seuil du transistor. De préférence, elle est la plus faible possible afin de limiter la consommation du transistor, mais doit rester suffisante pour pouvoir assurer un bon niveau de courant dans le canal 230.

Selon le document [1], cette structure de transistor 222 permet de lutter contre des effets de canal court et a de meilleures performances en terme de consommation que la structure classique de transistor 111 illustrée sur la figure 1. En effet, pour des tensions égales appliquées sur la grille 140 de la structure classique de transistor 111 et sur la grille 240 de la seconde structure de transistor de 222, à surfaces de contact entre grille et canal S₁ et S₂ égales, on obtient un courant de canal supérieur pour la structure de transistor 222 illustrée sur la figure 2.

La structure de transistor 222 pose néanmoins des problèmes, notamment en terme de densité d'intégration.

Cette structure, pour rester efficace, prend généralement plus de place sur un substrat sur lequel elle a été formée, qu'une structure classique comme la structure 111 de la figure 1. Pour former la structure de transistor 222 tout en tenant compte de contraintes en terme de courant, on essaie de réaliser des barreaux 202 ayant des largeurs W₂ les plus faibles possibles, avec des espaces 201 entre les barreaux 202 également les plus faibles possible. Mais, les largeurs W₂ des barreaux 202, ainsi que les largeurs Wₑ sont limitées car dépendantes des dimensions minimales que l'on peut obtenir par les procédés de photolithographie puis de gravure actuels ou nécessitent d'employer des procédés de gravure de photolithographie ou de gravure complexes et difficilement reproductibles.

En plus d'améliorer la vitesse et la consommation des transistors, on cherche également continuellement à améliorer leur densité d'intégration sur des puces ou des circuits intégrés.

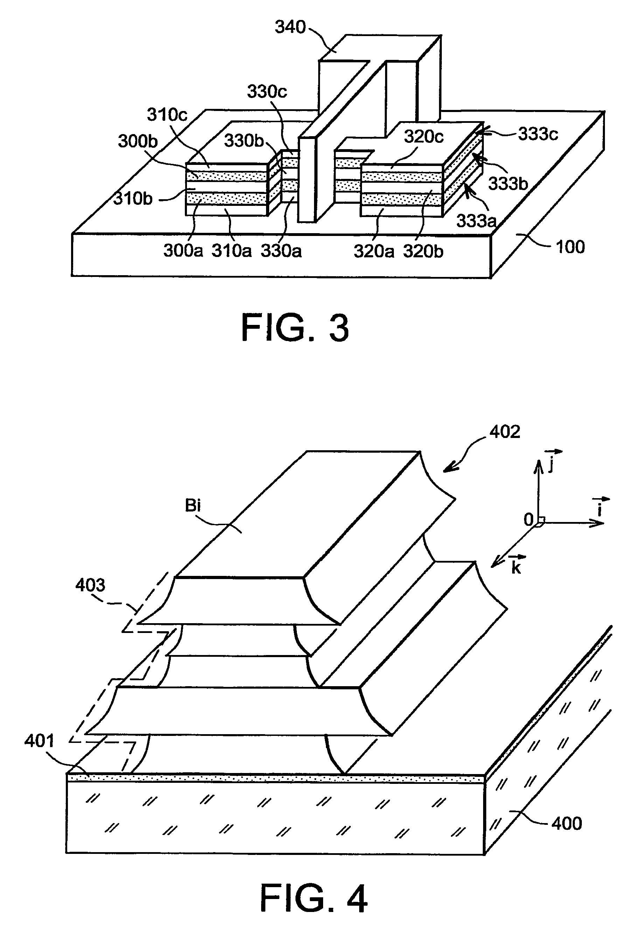

Un dispositif microélectronique illustré sur la figure 3 et décrit dans le document [2] référencé à la fin de la présente description, propose notamment une solution pour améliorer la densité d'intégration des transistors dans une puce. Ce dispositif comprend un substrat 100, de préférence isolant électriquement, sur lequel sont empilés trois transistors 333a, 333b, 333c, à grille commune séparés entre eux par une première couche diélectrique 300a et une deuxième couche diélectrique 300b intercalées. Chacun des transistors 333a, 333b, 333c, comporte une zone rectangulaire formant une source notée respectivement 310a, 310b, 310c, et une seconde zone rectangulaire formant un drain notée respectivement 320a, 320b, 320c. Chacune des sources 310a, 310b, 310c et des drains 320a, 320b, 320c sont respectivement reliés par des barreaux conducteurs de forme parallélépipédique formant des canaux et notés 330a, 330b, 330c.

Par ailleurs, une grille 340 commune aux trois transistors 333a, 333b, 333c recouvre partiellement l'empilement de canaux 330a, 330b, 330c. Un transistor ayant une structure latéralement dentelée est connu de US-6,562,665.

### EXPOSÉ DE L'INVENTION

La présente invention a pour but de présenter un dispositif microélectronique à effet de champ comportant une structure formant un ou plusieurs canaux de transistor. Cette structure, formant un ou plusieurs canaux de transistors, apporte aux transistors à effet de champ des améliorations, notamment en terme de densité d'intégration et en terme de performances électriques.

La présente invention selon la revendication 1 concerne dispositif microélectronique à effet de champ comprenant :
a) un substrat
b) au moins une structure formant un ou plusieurs canaux aptes à relier, dans le sens de leurs longueurs, une ou plusieurs sources et un ou plusieurs drains, ladite structure étant bâtie d'un empilement dans une direction orthogonale à un plan principal du substrat d'au moins deux barreaux de largeurs différentes réalisant un profil dentelé, par exemple en créneaux.

Ledit profil s'étend dans au moins une direction présentant un angle non nul avec le plan principal du substrat ou dans au moins une direction orthogonale au plan principal du substrat.

Ladite structure formant un ou plusieurs canaux comprise dans le dispositif suivant l'invention, peut permettre un gain de place par rapport à une structure, telle qu'illustrée sur la figure 2, comportant des barreaux juxtaposés.

Par ailleurs, des largeurs différentes de barreaux, ou encore un profil dentelé ou en créneau de ladite structure formant un ou plusieurs canaux, permettent ou permet d'améliorer le contrôle de la conduction du ou des canaux par une grille venant recouvrir, au moins partiellement, ladite structure. En effet, la surface de contact entre ce ou ces canaux et la grille est alors augmentée. D'autre part, ceci permet d'utiliser un phénomène de conduction entre la grille et les barreaux, confinée au niveau des arêtes ou/et des bords de ces derniers.

La structure peut être formée uniquement de barreaux susceptibles d'assurer une conduction électrique. Elle permet alors de former un canal unique de transistor, comportant un profil dentelé ou en créneau.

Selon une variante, ladite structure peut être formée d'un ou plusieurs barreaux susceptibles d'assurer une conduction électrique et d'un ou plusieurs barreaux non conducteurs pouvant par exemple servir de support mécanique aux autres barreaux de la structure. Ainsi, la structure peut permettre de former un seul canal, apte à relier une source et un drain de transistor, et comportant plusieurs barreaux conducteurs séparés entre eux par lesdits barreaux non conducteurs. Lesdits barreaux non conducteurs peuvent être à base de matériau isolant tel que par exemple du SiO₂. La structure peut également former plusieurs canaux, aptes à relier plusieurs sources et plusieurs drains de transistors, et séparés entre eux par des barreaux non conducteurs.

L'empilement peut comprendre au moins deux barreaux successifs à base de matériaux différents. Ainsi, l'empilement peut comprendre au moins deux barreaux successifs à base de matériaux semi-conducteurs différents ou de dopages différents. Par exemple au moins deux barreaux successifs dont un est à base de Si et l'autre à base de SiGe ou bien par exemple dont un est à base de Si dopé N et l'autre est à base de Si non dopé ou dopé P.

L'empilement peut également comprendre au moins deux barreaux successifs dont un premier est à base d'un matériau semi-conducteur tel que par exemple le Si ou le SiGe et dont un deuxième est à base d'un matériau isolant tel que par exemple du SiO₂.

La nature du matériau formant les barreaux peut dépendre notamment des propriétés du point de vue de la conduction électrique, que l'on souhaite donner à ladite structure.

Des barreaux à base de matériaux semi-conducteurs, en fonction de leurs épaisseurs ou/et selon qu'ils ont été, ou non, dopés, sont susceptibles d'assurer une conduction électrique.

L'empilement peut comprendre par exemple au moins un barreau à base d'un matériau semi-conducteur, tel que le silicium, le SiGe (siliciure de Germanium), le Germanium (Ge), l'arséniure de Galium (GaAs), éventuellement dopé, et au moins un barreau à base d'un deuxième matériau semi-conducteur, tel que le Si, le Ge, le GaAs, le SiGe, éventuellement dopé. Par ailleurs, l'empilement peut être formé d'une alternance de barreaux à base de matériaux semi-conducteurs différents ou/et de dopages différents tels que par exemple une alternance de barreaux à base de Si et de barreaux à base de SiGe ou d'une alternance de barreaux à base de Ge et de barreaux à base de GaAs, ou d'une alternance de barreaux à base de SiGe et de barreaux à base de Ge, ou encore d'une alternance de barreaux en silicium non dopé et de barreaux en silicium dopé N ou P.

L'empilement peut également être formé d'une alternance de barreaux à base de matériau semi-conducteur et de barreaux à base d'un matériau isolant tels que par exemple une alternance de barreaux à base de Si ou SiGe et de barreaux à base de SiO₂.

Les barreaux peuvent avoir chacun des épaisseurs différentes ainsi que des longueurs différentes. Des barreaux susceptibles d'assurer une conduction électrique peuvent avoir une épaisseur par exemple comprise entre 3 et 100 nanomètres et avantageusement entre 5 et 15 nanomètres.

Les barreaux susceptibles d'assurer une conduction électrique peuvent avoir une épaisseur faible, inférieure à 10 nm, par exemple comprise entre 1 nm et 10 nm, permettant d'obtenir un bon confinement des porteurs de charges dans ces barreaux.

Des barreaux non conducteurs peuvent par exemple avoir une épaisseur comprise entre 3 et 100 nanomètres. Avantageusement, les barreaux conducteurs et les barreaux non conducteurs ont des tailles de même ordre de grandeur.

Selon une caractéristique particulière de l'invention, un ou plusieurs barreaux, par exemple des barreaux non conducteurs ou semi-conducteurs, peuvent être entourés au moins partiellement, dans une direction parallèle à un plan principal du substrat, de bouchons isolants. Ces bouchons isolants peuvent être à base d'un matériau diélectrique tel que par exemple du nitrure.

Selon une caractéristique particulière du dispositif microélectronique à effet de champ selon l'invention, ce dernier peut comprendre en outre un masque dur sur ledit empilement.

Le masque dur peut être formé à base d'oxyde de silicium ou de nitrure, il peut permettre d'empêcher une conduction parasite sur le dessus de l'empilement et d'éviter ainsi la formation d'un canal parasite.

Selon une caractéristique particulière du dispositif microélectronique à effet de champ selon l'invention, ce dernier peut comprendre en outre une grille pouvant recouvrir au moins partiellement ladite structure et éventuellement le masque dur. Les bouchons isolants peuvent alors permettre par exemple d'empêcher une conduction électrique entre une grille recouvrant ladite structure et les barreaux non conducteurs ou semi-conducteurs de ladite structure.

Le dispositif selon l'invention peut en outre comprendre une ou plusieurs sources reliées par ladite structure à un ou plusieurs drains.

L'invention selon la revendication 10 comprend en outre un procédé de réalisation d'un dispositif microélectronique à effet de champ doté d'au moins une structure comportant au moins deux barreaux empilés de largeurs différentes apte à former un ou plusieurs canaux de transistors. Le procédé suivant l'invention comprend les étapes de :
- formation, sur un substrat d'un empilement de plusieurs couches comportant au moins deux couches successives à base de matériaux différents,
- formation d'au moins un masque sur ledit empilement,
- gravure anisotrope des couches à travers le masque,
- gravure partielle et sélective d'une ou plusieurs couches de l'empilement.

Ledit masque peut comprendre un masque de résine.

Avantageusement, ledit masque peut comprendre un masque de résine et un masque dur empilés. Le masque dur peut être par exemple à base de nitrure ou de SiO₂ et permettre de faciliter la gravure des couches de l'empilement.

Le masque dur peut également permettre s'il est conservé à la fin du procédé, d'isoler électriquement le dessus de l'empilement.

De manière avantageuse, la gravure partielle et sélective des couches de l'empilement peut être isotrope.

L'empilement peut comprendre au moins deux couches à base de matériaux semi-conducteurs différents ou de dopages différents choisis parmi les matériaux suivants : Si, SiGe, Ge, GaAs, Si dopé N, Si dopé P.

Selon une autre caractéristique particulière du procédé suivant l'invention, ledit empilement peut comprendre au moins une couche à base de matériau isolant et une couche à base de matériau semi-conducteur.

Le procédé suivant l'invention peut comprendre en outre : le dépôt conforme d'une couche diélectrique, par exemple à base de nitrure, sur ladite structure. Le procédé suivant l'invention peut alors comprendre en outre, la gravure isotrope au moins partielle de ladite couche diélectrique, de manière à former des bouchons isolants autour de certains barreaux de ladite structure.

Selon une possibilité de mise en oeuvre, le procédé suivant l'invention peut comprendre en outre : la formation d'une grille recouvrant au moins partiellement ladite structure et éventuellement le masque dur.

Selon une mise en oeuvre particulière, cette grille peut être réalisée par un procédé de type damascène. La formation de la grille peut alors comprendre les étapes consistant à :
- recouvrir la structure d'une couche isolante,
- réaliser au moins une ouverture dans la couche isolante de manière à dévoiler ladite structure,
- recouvrir la structure d'un diélectrique ou isolant de grille tel que par exemple du HfO₂ ou du SiO₂,
- remplir l'ouverture d'un matériau de grille tel que par exemple du polysilicium, ou un métal réfractaire.

Selon une variante de mise en oeuvre du procédé, préalablement à la formation de la grille, une ou plusieurs étapes de dopage de ladite structure peuvent être réalisées.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1, 2, 3 déjà décrites représentent des structures de transistors à effet de champ comportant chacune une structure de canal selon l'art connu ;
- les figures 4, 5, 6A, 6B, 7, 8 représentent des exemples de dispositifs microélectroniques à effet de champ selon l'invention ;
- les figures 9A-9H représentent un premier exemple de procédé de réalisation d'un dispositif microélectronique suivant l'invention ;
- la figure 10 représente un exemple de motif que peut comporter un masque dur utilisé lors de l'exemple de procédé de réalisation suivant l'invention illustré par les figures 9A-9H et décrit plus bas ;
- les figures 11A-11D représentent un mode de réalisation particulier d'un procédé de réalisation d'un dispositif microélectronique suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

La figure 4 illustre un exemple de dispositif microélectronique suivant l'invention. Elle représente un substrat 400 par exemple à base de matériau semi-conducteur, recouvert d'une couche isolante 401. Une structure 402 repose sur le substrat 400. Elle est bâtie selon un empilement, dans une direction orthogonale à un plan principal du substrat 400, de plusieurs barreaux Bᵢ, à base par exemple de matériau semi-conducteur.

Par plan principal du substrat 400, on entend un plan parallèle à la surface de la couche 401, ou passant par le substrat 400 et parallèle à un plan [O; ***̅i̅*̅** ; ***̅k̅*̅**] d'un repère orthogonal [O; ***̅i̅*̅**; ***̅j̅*̅**; ***̅k̅*̅**] illustré sur la figure 4.

Ce dispositif peut être obtenu à l'aide de procédés de réalisation en couches minces. On entend par barreaux : des blocs, des zones ou des ailettes de formes sensiblement parallélépipédiques extraites de couches minces.

Les barreaux sont obtenus par exemple par gravure de ces couches minces. Or, certains procédés de gravure de couches minces ne permettent pas toujours d'obtenir des formes géométriques parfaites. Ainsi, lorsqu'on emploiera le terme de «barreaux» dans la présente description, on ne souhaite pas se limiter à des barreaux ou blocs ayant une forme parfaitement parallélépipédique. On souhaite aussi inclure des barreaux dont la forme se rapproche de celle d'un parallélépipède,

Les barreaux Bᵢ de la structure 402 ont des largeurs différentes, mesurées dans une direction parallèle à celle définie par le vecteur ***̅i̅*̅** du repère orthogonal [O; ***̅i̅*̅**; *̅j̅*̅ ; **k̅**]. Il en résulte que la structure 402 présente un profil dentelé 403 (représenté en pointillé sur la figure 4), s'étendant dans au moins une direction orthogonale au plan principal ou dans une direction présentant un angle non nul avec le plan principal du substrat. Dans le cas où les barreaux ont une forme très proche de la forme parallélépipédique, le profil dentelé 403 peut être un profil en créneaux.

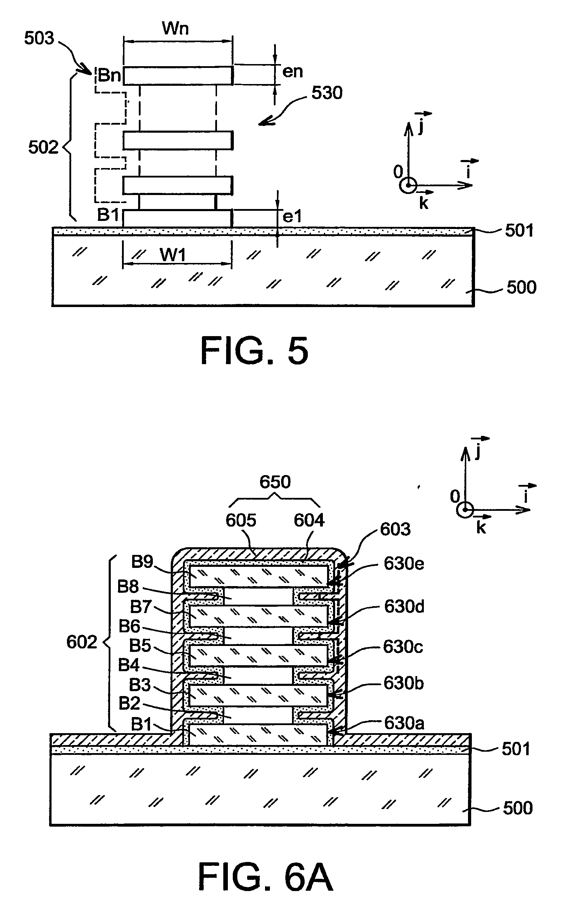

La figure 5 illustre un autre exemple de dispositif microélectronique selon l'invention.

Un substrat 500, par exemple à base d'un matériau semi-conducteur tel que par exemple du silicium est recouvert par une couche isolante par exemple à base de SiO₂. Sur la couche isolante 501 repose une structure 502 bâtie selon un empilement de plusieurs barreaux B₁,...,Bₙ.

Les barreaux B₁, ..., Bₙ, sont empilés dans une direction orthogonale à un plan principal du substrat 500, soit une direction parallèle à la direction définie par un vecteur ***̅j̅*̅** du repère orthogonal [O; ***i̅** ; **j̅** ; **k̅***] illustré sur la figure 5.

Les barreaux B₁, ..., Bₙ ont chacun une forme sensiblement parallélépipédique et sont illustrés, selon une coupe transversale.

Les barreaux B₁, ..., Bₙ ont des longueurs qui peuvent être identiques ou différentes, et qui sont mesurées dans une direction parallèle à la direction définie par le vecteur ***̅k̅*̅** du repère orthogonal [O; ***i̅** ; j̅ ; **k̅***]. Les longueurs des barreaux B₁, ..., Bₙ ne sont pas référencées sur la figure 5, étant donné la vue en coupe transversale.

Les barreaux B₁, ..., Bₙ ont des largeurs W₁, ..., Wₙ différentes, mesurées dans une direction parallèle à celle définie par le vecteur ***̅i̅*̅** du repère [O; ***̅i̅*̅**; ***̅j̅*̅**; ***̅k̅*̅**]. Les largeurs W₁, ..., Wₙ sont comprises par exemple entre 10 nanomètres et 1 µm. Les barreaux B₁, ..., Bₙ ayant des largeurs différentes, la structure 502 présente un profil 503 dentelé représenté en pointillé sur la figure 5, qui s'étend dans au moins une direction orthogonale au plan principal du substrat 500.

Les barreaux B₁, ..., Bₙ peuvent également avoir des épaisseurs e*₁*,...,e*ₙ* différentes les unes par rapport aux autres, mesurées dans une direction parallèle à celle définie par le vecteur ***̅j̅*̅** du repère [O; ***̅i̅*̅**; ***̅j̅*̅**; ***̅k̅*̅**]. Les épaisseurs e₁, ..., eₙ sont comprises par exemple entre 3 et 100 nanomètres ou avantageusement entre 5 et 15 nanomètres.

Les n barreaux B₁, ..., Bₙ peuvent être tous réalisés à base d'un même matériau semi-conducteur ou bien à base de plusieurs matériaux semi-conducteurs différents, tels que par exemple du silicium, éventuellement dopé, ou bien du SiGe, éventuellement dopé, ou bien du Germanium, éventuellement dopé, ou bien de l'arséniure de Gallium, éventuellement dopé.

La structure 502 forme un canal de transistor 530 présentant un profil 503 dentelé susceptible de joindre une première zone sur le substrat 500 formant une source (non représentée sur la figure 5) et une seconde zone sur le substrat 500 formant un drain (non représenté sur la figure 5).

Le canal 530 pourra être recouvert par une grille venant épouser le profil 503 dentelé. Ce profil 503 dentelé permettra, dans ce cas, d'obtenir une surface de contact entre ladite grille et le canal 530 plus importante que celle que l'on obtiendrait avec un canal classique de même dimensions mais comportant un profil plan.

La figure 6A illustre un autre exemple de dispositif microélectronique selon l'invention. Une structure 602, reposant sur un substrat 500 recouvert d'une couche isolante 501, est bâtie selon un empilement de 9 barreaux B₁, ..., B₉ empilés dans cet ordre, et ayant chacun une forme sensiblement parallélépipédique.

Les barreaux B₁, ..., B₉, sont représentés sur la figure 6A selon une coupe transversale. Les barreaux B₁, B₃, B₅, B₇, B₉, ont des largeurs respectives W₁, W₃, W₅, W₇, W₉, sensiblement les mêmes, mesurées dans une direction parallèle à celle définie par le vecteur ***̅i̅*̅** du repère orthogonal [O; ***̅i̅*̅** ; ***̅j̅*̅** ; ***̅k̅*̅** ] illustré à la figure 6A. Les largeurs W₁, W₃, W₅, W₇, W₉ sont comprises par exemple entre 5 nm et quelques micromètres (par exemple 5 µm) et avantageusement entre 10 nm et 100 nm. Les barreaux B₁, B₃, B₅, B₇, B₉, sont alternativement empilés avec les barreaux B₂, B₄, B₆, B₈, ayant des largeurs respectives W₂, W₄, W₆, W₈, comprises par exemple entre 5 nm et quelques µm (par exemple 5 µm), avantageusement entre 5 nm et 95 nm, et inférieures aux largeurs W₁, W₃, W₅, W₇, W₉.

Les barreaux B₁, ..., B₉ ont de plus des longueurs différentes les unes par rapport aux autres, mesurées dans une direction parallèle à celle définie par le vecteur ***̅k̅*̅** du repère orthogonal [O; ***̅i̅*̅** ; ***̅j̅*̅** ; ***̅k̅*̅**].

Les barreaux B₁, ..., B₉ sont réalisés à base d'un matériau semi-conducteur comme par exemple du silicium, éventuellement dopé. De par leurs natures ou compositions et/ou le niveau de dopage du matériau semi-conducteur, les barreaux B₁, B₃, B₅, B₇, B₉ sont susceptibles d'assurer une conduction électrique. Ils peuvent ainsi former un canal ou éventuellement plusieurs canaux, de transistors.

Les barreaux B₁, B₃, B₅, B₇, B₉, ont des épaisseurs e₁, e₃, e₅, e₇, e₉, mesurées dans des directions parallèles à celles définies par le vecteur ***̅j̅*̅** du repère orthogonal [O; ***̅i̅*̅** ; ***j̅** ; **k̅***]. Les épaisseurs e₁, e₃, e₅, e₇, e₉, sont par exemple inférieures à 15 nanomètres, afin de permettre un confinement de porteurs de charges dans les barreaux B₁, B₃, B₅, B₇, B₉ lorsque ces derniers assurent une conduction électrique.

Les barreaux B₂, B₄, B₆, B₈ ont des épaisseurs e₂, e₄, e₆, e₈, comprises par exemple entre 3 et 100 nanomètres, avantageusement entre 5 et 15 nanomètres. Ils peuvent comprendre un matériau semi-conducteur comme par exemple du SiGe non dopé ou un matériau isolant tel que du SiO₂. Les barreaux B₂, B₄, B₆, B₈, sont non conducteurs ou semi-conducteurs, ils peuvent servir par exemple de soutien mécanique à la structure 602 et d'isolation entre les barreaux B₁, B₃, B₅, B₇, B₉.

De par les largeurs différentes des barreaux B₁, ..., B₉ et la forme sensiblement parallélépipédique de ces mêmes barreaux, la structure 602 présente un profil en créneau 603 qui s'étend dans au moins une direction orthogonale à un plan principal du substrat 500.

La structure 602 est en outre recouverte par une grille 650 formée tout d'abord d'une couche d'isolant de grille 604, d'épaisseur comprise par exemple entre 0,5 nm et 50 nanomètres, qui suit le profil en créneau. La couche d'isolant de grille 604 peut être par exemple à base de SiO₂ ou de Si₃N₄, ou de tout autre matériau diélectrique pouvant servir d'isolant de grille.

La grille 650 est également formée d'une autre couche de matériau de grille 605 recouvrant la couche d'isolant de grille 604 et embrassant le profil en créneau. La couche de matériau de grille 605 peut être réalisée par exemple à base d'un matériau semi-conducteur, tel que du polysilicium éventuellement dopé ou siliciuré (partiellement ou totalement), du SiGe, ou même à base par exemple d'un métal réfractaire. Le profil en créneau 603 permet à la grille 650 d'avoir une surface de contact importante avec la structure 602, et par conséquent, une bonne surface de conduction avec les barreaux B₁, B₃, B₅, B₇, B₉, susceptibles d'assurer une conduction électrique.

Le profil en créneau 603 peut par ailleurs permettre une conduction confinée dans les coins des barreaux B₁, B₃, B₅, B₇, B₉, lorsque ces derniers assurent une conduction électrique.

La structure 602 est susceptible de relier dans le sens de sa longueur, parallèle à un plan principal du substrat 500, une première région réalisée sur le substrat 500 formant plusieurs sources de transistors, et une seconde région également réalisée sur le substrat 500 formant plusieurs drains de transistors. Les barreaux B₁, B₃, B₅, B₇, B₉ de la structure 602 réalisent alors cinq canaux 630a, 630b, 630c, 630d, 630e, alignés et parallèles entre eux dans un plan orthogonal à un plan principal du substrat. Les canaux sont séparés entre eux par les barreaux B₂, B₄, B₆, B₈ non conducteurs ou semi-conducteurs.

Le nombre de barreaux de la structure ainsi que le nombre de canaux que réalise la structure ne sont pas limités.

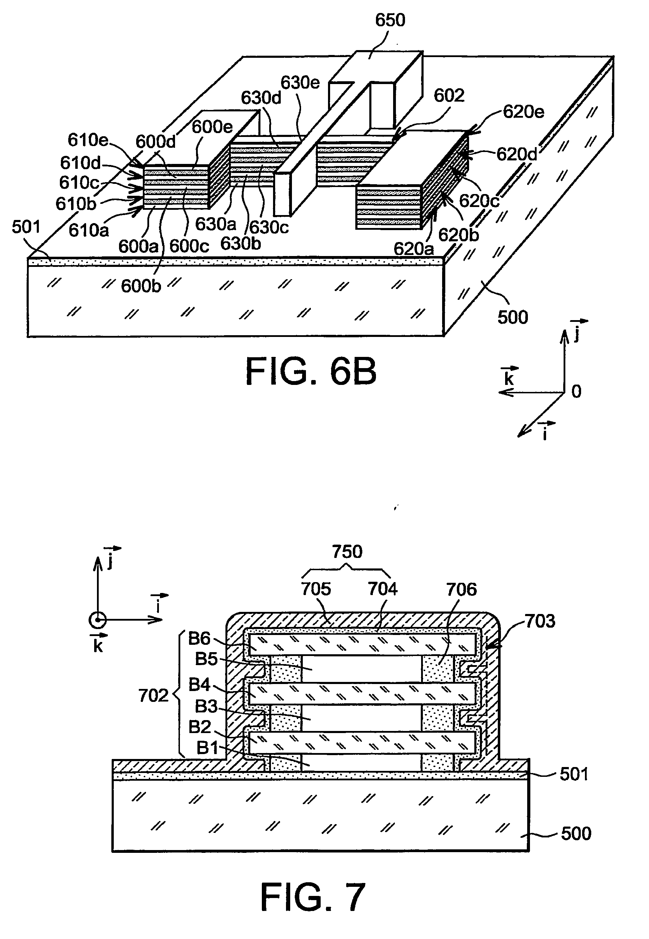

La figure 6B illustre une variante du dispositif microélectronique illustré sur la figure 6A. La structure 602 décrite plus haut est représentée sur la figure 6B dans toute sa longueur et en perspective. Le repère orthogonal [O; ***̅i̅*̅** ; ***̅j̅*̅** ; ***̅k̅*̅**] illustré sur la figure 6B est le même que celui de la figure 6A.

Le dispositif microélectronique de la figure 6B diffère de celui de la figure 6A, en ce qu'il comprend en outre, une première région sur le substrat 500 comportant 5 sources 610a, 610b, 610c, 610d, 610e empilées, de transistors différents. Les sources 610a, 610b, 610c, 610d, 610e sont séparées entre elles par 4 couches 600a, 600b, 600c, 600d non conductrices et par exemple à base d'un matériau isolant tel que le SiO₂ ou semi-conductrices et par exemple à base d'un matériau semi-conducteur tel que le SiGe. Les sources 610a, 610b, 610c, 610d, 610e sont reliées via les 5 canaux 630a, 630b, 630c, 630d, 630e de la structure 602, à une seconde région comportant 5 drains 620a, 620b, 620c, 620d, 620e de transistors différents également empilés et également séparés entre eux par les 4 couches 600a, 600b, 600c, 600d non conductrices ou semi-conductrices. Une grille 650 est commune aux canaux 630a, 630b, 630c, 630d, 630e. La grille 650 recouvre partiellement la structure 602, dans une direction parallèle à celle définie par le vecteur ***̅k̅*̅** du repère [O; ***̅i̅*̅** ; ***̅j̅*̅** ; ***̅k̅*̅**]. La grille 650 est cependant en contact avec tous les canaux 630a, 630b, 630c, 630d, 630e par l'intermédiaire de l'oxyde de grille.

Selon une caractéristique particulière du dispositif microélectronique illustré à la figure 6B, l'empilement des sources 610a, 610b, 610c, 610d, 610e et l'empilement des drains 620a, 620b, 620c, 620d, 620e réalise un profil en créneau, comme celui de la structure 602.

La figure 7 représente un autre exemple de dispositif microélectronique suivant l'invention comprenant un substrat 500 recouvert par une couche isolante 501. Une structure 702 comportant 6 barreaux B₁,...,B₆ issus de couches minces repose sur la couche isolante 501. Les barreaux B₁, ..., B₆ sont illustrés en coupe transversale sur la figure 7. Ils ont des largeurs différentes les unes par rapport aux autres, mesurées dans une direction parallèle à celle définie par le vecteur ***̅i̅*̅** du repère orthogonal [O; ***̅i̅*̅** ; ***j̅** ; **k̅***].

La structure 702 présente par ailleurs un profil en créneaux 703. Les barreaux B₂, B₄, B₆, sont aptes à assurer une conduction électrique.

Les barreaux B₁, B₃, B₅, sont non conducteurs et peuvent être à base d'un matériau isolant tel que SiO₂. Ils peuvent être également semi-conducteurs à base d'un matériau tel que du SiGe par exemple non dopé et n'assurer qu'une conduction très faible en comparaison des barreaux B₂, B₄, B₆, voire quasi-nulle.

La structure 702 comporte en outre des bouchons d'isolation entourant les barreaux B₁, B₃, B₅ et s'étendant dans la même direction que ces derniers. Les bouchons isolants 706 peuvent être à base d'un matériau diélectrique tel que par exemple du nitrure.

La structure 702 est recouverte d'une couche 704 d'isolant de grille, d'épaisseur comprise par exemple entre 2 et 50 nanomètres, qui suit le profil en créneau 703. La couche 704 d'isolant de grille peut être par exemple à base de SiO₂ ou de Si₃N₄, ou de tout autre matériau diélectrique pouvant servir d'isolant de grille. La couche 704 d'isolant de grille est recouverte par une seconde couche 705 embrassant le profil en créneaux 703 de la structure 702. La couche 705 est par exemple à base d'un matériau semi-conducteur tel que du polysilicium éventuellement dopé, du SiGe, etc. ou d'un métal réfractaire. L'ensemble formé par la couche 704 d'isolant de grille et la couche 705 forment une grille 750 pour un ou plusieurs transistors.

Les bouchons d'isolation 706 décrits plus haut peuvent servir à empêcher toute conduction électrique entre la grille et les barreaux B₁, B₃, B₅.

Les barreaux B₂, B₄, B₆ pourront former un ou plusieurs canaux de transistors, selon que la structure 702 est reliée à une ou plusieurs sources et à un ou plusieurs drains de transistors.

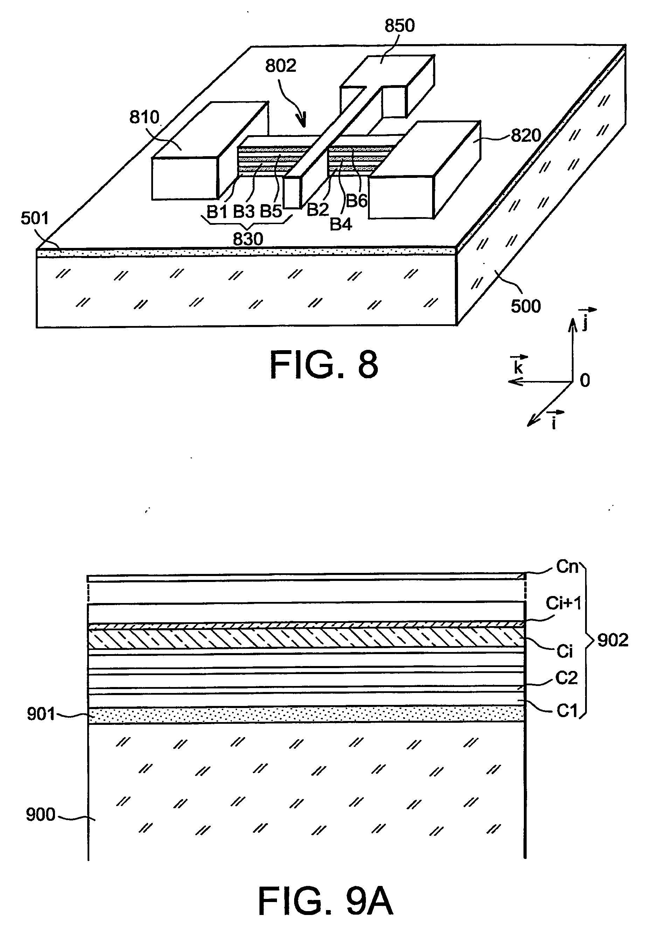

La figure 8 représente un autre exemple de dispositif microélectronique suivant l'invention : le dispositif comprend un substrat 500, recouvert par une couche isolante 501. Sur la couche isolante 501 repose une première zone formant une source 810 ainsi qu'une seconde zone formant un drain 820. La source 810 et le drain 820 sont reliés entre eux par une structure 802 bâtie d'un empilement, dans une direction orthogonale à un plan principal du substrat, de 6 barreaux B₁, ..., B₆, à base de matériaux différents. La structure 802 peut être réalisée par exemple à base d'une alternance de barreaux à base d'un matériau semi-conducteur B₁, B₃, B₅, et de barreaux à base d'un matériau isolant B₂, B₄, B₆. Les barreaux ont dans cet exemple des longueurs et des largeurs sensiblement identiques. Les barreaux B₁, B₃, B₅, sont susceptibles d'assurer une conduction électrique entre la source 810 et le drain 820, ils forment donc à eux trois un canal 830 unique de transistor reliant la source 810 et le drain 820. Une grille 850, apte à contrôler la conduction du canal 830, recouvre partiellement la structure 802 dans une direction parallèle à celle définie par un vecteur ***̅k̅*̅** du repère [O; ***̅i̅*̅**; ***̅j̅*̅**; ***̅k̅*̅**] illustré sur la figure 8.

Selon une variante du dispositif illustré sur la figure 8, la structure 802 est remplacée, par la structure 702 comprenant un profil en créneaux 703, illustrée à la figure 7 et décrite plus haut.

Un premier exemple de procédé de réalisation d'un dispositif microélectronique à effet de champ suivant l'invention va à présent être décrit. Il est illustré par les figures 9A-9H,

La première étape de ce procédé illustrée par la figure 9A consiste à réaliser un empilement 902 de n couches C₁, ..., Cₙ (avec n supérieur à 2, une partie de l'empilement étant représentée de manière schématique à l'aide de traits discontinus), sur un substrat 900. Le substrat 900 peut être à base de silicium et recouvert d'une couche isolante 901, par exemple une couche SIMOX (couche de séparation par implantation d'oxygène) à base de SiO₂. Les n couches empilées peuvent être réalisées par exemple par épitaxie, ou par exemple par CVD (CVD pour « chemical vapor deposition » en français dépôt chimique en phase vapeur) en particulier par épitaxie. Les couches C₁,...,Cₙ ont des épaisseurs e₁,...,eₙ qui peuvent être différentes les unes par rapport aux autres et mesurées dans une direction orthogonale à un plan principal du substrat 500.

Les épaisseurs e₁, ..., eₙ peuvent être par exemple comprises entre 3 et 100 nanomètres ou entre 5 et 15 nanomètres. Les couches C₁, ..., Cₙ peuvent être réalisées par exemple à base de différents matériaux semi-conducteurs tels que du silicium ou du SiGe ou du GaAs, ou du Ge. Certaines des couches de l'empilement 902 peuvent également être réalisées à base d'un matériau isolant tel que par exemple le SiO₂.

L'empilement 902 comprend au moins deux couches successives Cᵢ, Cᵢ₊₁ (avec i ∈ [1;n]) de matériaux différents. Dans le cas où la couche Ci est réalisée à base d'un premier matériau semi-conducteur tel que du Si, la couche Cᵢ₊₁ peut être réalisée à base d'un second matériau semi-conducteur différent du premier tel que par exemple du SiGe ou à base d'un second matériau semi-conducteur dopé, de dopage différent du premier matériau tel que par exemple du Si dopé N ou P. Le second matériau peut être également à base d'un matériau isolant tel que par exemple du SiO₂.

Selon une caractéristique particulière du procédé suivant l'invention, l'empilement peut être réalisé par une alternance de couches à base de matériau semi-conducteur tel que le silicium et de couches à base de matériau isolant tel que par exemple du SiO₂, ou bien d'une alternance de couches à base d'un premier matériau semi-conducteur et de couches à base d'un second matériau semi-conducteur.

L'empilement peut être réalisé par exemple par une alternance de couches à base de Si et de couches à base de SiGe ou par exemple d'une alternance de couches à base de Ge et de couches à base de AsGa, ou par exemple d'une alternance de couches à base de SiGe et de couches à base de Ge, ou encore par exemple d'une alternance de couches à base de Si dopé N ou P et de couches à base de Si non dopé.

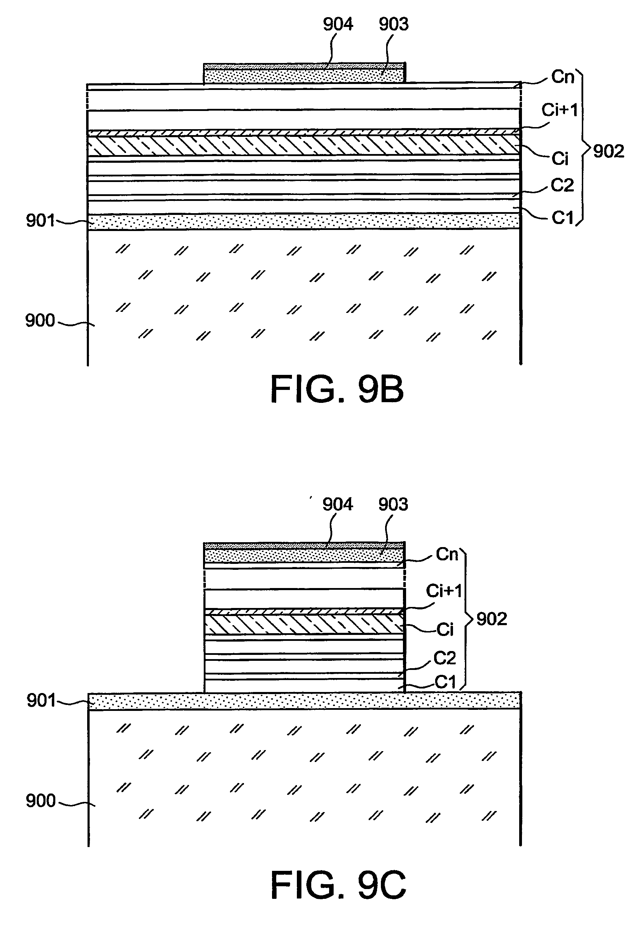

Une fois l'empilement 902 réalisé, on effectue le dépôt d'une couche de masque dur sur l'empilement 902 par exemple à base de Si₃N₄ ou de SiO₂ ou à base de tout autre matériau apte à protéger l'empilement 902 d'une gravure telle que par exemple une gravure plasma. Ensuite, on dépose une couche de résine photosensible par exemple à base de polyimide sur la couche de masque dur. On définit dans la couche de résine, par exemple par une méthode de photolithographie, un masque de résine 904 comportant un ou plusieurs motifs. Ensuite, on effectue une gravure anisotrope de la couche de masque dur protégée par le masque de résine 904 pour réaliser un masque dur 903 sous le masque de résine 904 et reproduisant les motifs de ce dernier (figure 9B).

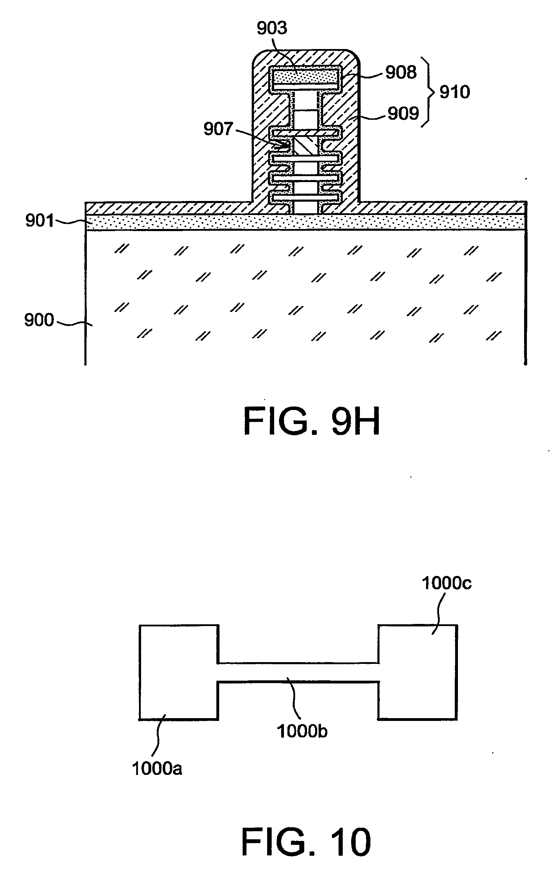

Le masque dur 903 comporte au moins un motif de canal de transistor 1000b, par exemple de forme rectangulaire et tel que celui illustré sur la figure 10, reliant un motif de source 1000a de transistor, et un motif de drain 1000c de transistor.

On retire ensuite le masque de résine 904 par un procédé classique de décapage, par exemple à l'aide d'un plasma oxydant. On procède alors à une première étape de gravure des n couches C₁, ..., Cₙ situées sous le masque dur 903.

Selon une variante du procédé, une fois l'empilement 902 réalisé, on peut effectuer le dépôt d'une couche de résine directement sur l'empilement sans déposer de couche de masque dur, puis former le masque de résine 904 par photolithographie. On effectue alors la première étape de gravure à travers le masque de résine 904.

La première étape de gravure peut comprendre la gravure anisotrope des n couches C₁, ..., Cₙ à travers le masque dur 903, de sorte que les n couches C₁, ..., Cₙ gravées de l'empilement, reproduisent les motifs du masque dur 903 (figure 9C) et notamment le motif de canal 1000b du masque dur (non illustré sur la figure 9C).

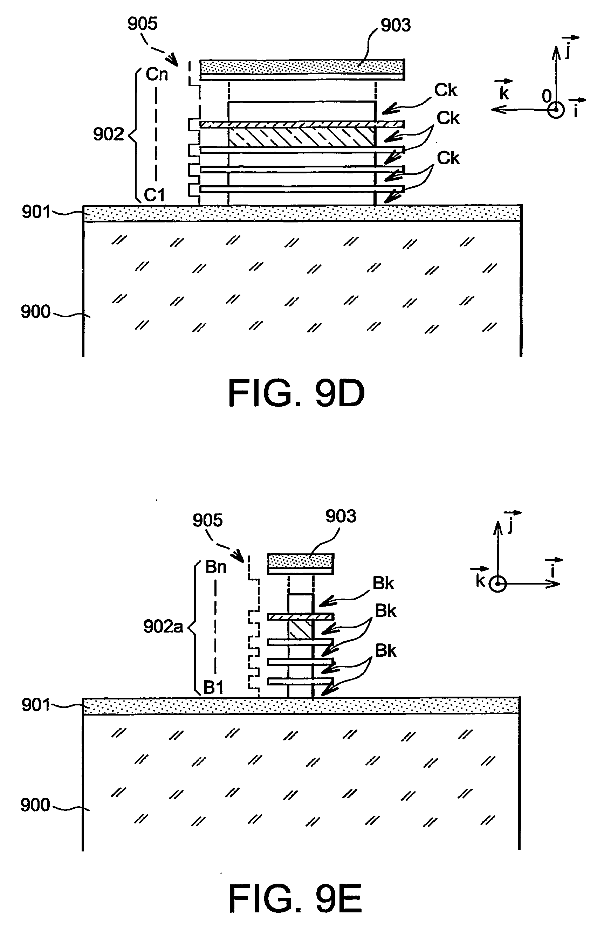

Puis, une seconde étape de gravure sélective isotrope d'une ou plusieurs couches Cₖ (k ∈ [1,n]) parmi les n couches C₁,..., Cₙ est effectuée et permet de retirer partiellement les couches Cₖ (figure 9D). Les couches Cₖ de l'empilement 902 ont des étendues inférieures à celles des autres couches. Il en résulte que l'empilement 902 comporte un profil dentelé 905, s'étendant dans au moins une direction orthogonale au plan principal du substrat 900 ou dans au moins une direction présentant un angle non nul avec le plan principal du substrat 900.

De manière préférable, la seconde étape de gravure sélective impacte les couches Cₖ et laisse les autres couches intactes.

Selon une caractéristique particulière du procédé suivant l'invention, les couches Cₖ partiellement retirées par la gravure sélective sont à base d'un premier matériau semi-conducteur tel que par exemple du SiGe, alors que les autres couches de l'empilement sont à base par exemple d'un second matériau semi-conducteur tel que du Si. Les couches Cₖ partiellement retirées par la gravure sélective peuvent être également à base d'un matériau isolant tel que du SiO₂, alors que les autres couches de l'empilement sont à base d'un matériau semi-conducteur tel que du Si.

La figure 9E illustre une vue en coupe d'une partie de l'empilement 902. La coupe est réalisée selon un plan orthogonal au plan [O; ***̅j̅*̅**; ***̅k̅*̅**] du repère orthogonal [O; ***̅i̅*̅** ; ***̅j̅*̅** ; ***̅k̅*̅**] commun aux figures 9D et 9E.

La partie de l'empilement 902 illustrée à la figure 9E, est celle qui se trouve sous, et qui reproduit le motif de canal (illustré et noté 1000b sur la figure 10) du masque dur 903.

Cette partie de l'empilement se présente sous forme d'une structure 902a formée de n barreaux B₁, ..., Bₙ empilés, de formes sensiblement parallélépipédiques (une partie de l'empilement étant schématisé à l'aide de traits discontinus sur la figure 9E). Les barreaux B₁,...,Bₙ sont des portions des couches C₁, ..., Cₙ gravées qui reproduisent le motif de canal du masque dur 903. Les barreaux B₁, ..., Bₙ sont vus selon une coupe transversale. Ladite structure 902a comporte certains barreaux Bₖ, k ∈ [l,n], correspondant à une portion des couches Cₖ gravées de manière sélective. Ces barreaux Bₖ ont des largeurs Wₖ, mesurées dans des directions parallèles à celle définie par le vecteur ***̅i̅*̅** du repère orthogonal [O; ***̅i̅*̅**; ***̅j̅*̅**; ***̅k̅*̅**], inférieures à celles des autres barreaux.

Les barreaux B₁, ..., Bₙ empilés ayant des largeurs différentes, la structure 902a comporte également un profil 905 dentelé.

Selon une caractéristique particulière du procédé, le profil dentelé 905 de l'empilement 902 peut être un profil en créneaux. En effet, suivant la qualité de la gravure sélective précédemment décrite, les barreaux Bₖ peuvent avoir une forme proche d'une forme parfaitement parallélépipédique. Des barreaux empilés de forme proche d'une forme parfaitement parallélépipédique et de largeurs différentes les unes des autres réalisent un profil en créneaux.

Suivant la nature des matériaux qui composent les barreaux B₁, ..., Bₙ la structure 902a peut comporter un ou plusieurs barreaux susceptibles d'assurer une conduction électrique et, éventuellement, comporter un ou plusieurs barreaux non conducteurs. La structure 902a est ainsi susceptible de former un ou plusieurs canaux de transistors alignés et parallèles dans le plan [O; ***̅i̅*̅**; ***̅k̅*̅**] du repère orthogonal [O; ***̅i̅*̅** ; ***̅j̅*̅** ; ***̅k̅*̅**].

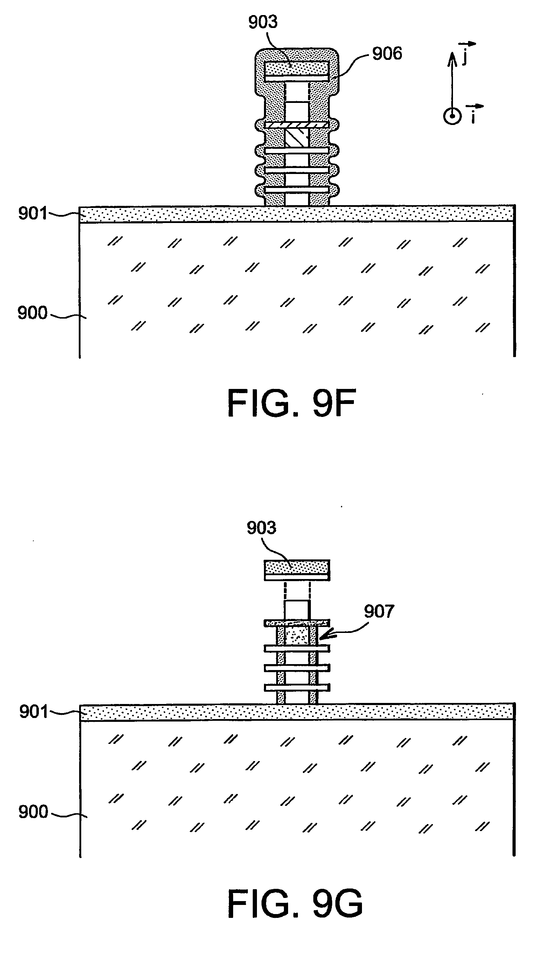

Selon une caractéristique particulière du procédé suivant l'invention, on peut ajouter à la structure 902a, des bouchons isolants 907 entourant les barreaux Bₖ dans une direction parallèle à un plan principal du substrat 900, c'est-à-dire dans une direction parallèle au plan [O; *̅i̅*̅; *̅k̅*̅]. La formation des bouchons isolants 907 comprend une étape de dépôt conforme d'une couche diélectrique 906 par exemple de 20 à 50 nanomètres de nitrure sur la structure 902a (figure 9F).

Puis, une gravure isotrope partielle de cette couche diélectrique 906 est effectuée. Cette gravure partielle est réalisée de manière à conserver une épaisseur de la couche diélectrique 906, de préférence uniquement autour des barreaux Bₖ. Cette épaisseur est suffisante pour limiter l'influence électrique sur les barreaux Bₖ d'une grille éventuellement formée ultérieurement sur la structure 902a. Par exemple cette épaisseur sera 10 fois supérieure à celle d'un isolant d'une grille éventuellement formée ultérieurement sur la structure 902a. L'épaisseur restante de la couche diélectrique forme alors les bouchons isolants 907 (figure 9G).

Selon une caractéristique particulière du procédé suivant l'invention, une fois la structure 902a réalisée, on peut procéder à la formation d'une grille recouvrant au moins partiellement, dans une direction parallèle au vecteur ***̅i̅*̅**, ladite structure 902a.

Selon une variante du procédé, et suivant la nature des barreaux B₁, ..., Bₙ, préalablement à la formation de la grille, une ou plusieurs étape de dopage de la structure 902a peuvent être prévues. Ce ou ces dopages pourront être par exemple de type P pour des transistors NMOS et par exemple de type N, pour des transistors PMOS. Ces étapes de dopages peuvent permettre notamment de diminuer les effets du canal court.

La formation de la grille peut être réalisée tout d'abord par dépôt, de préférence conforme, d'une couche d'isolant de grille 908 par exemple à l'aide d'un matériau isolant d'épaisseur de 2 à 50 nanomètres tel que par exemple du Si₃N₄, du SiO₂, ou un matériau isolant de haute constante diélectrique. La couche d'isolant de grille 908 suit le profil dentelé de la structure 902a. Ensuite, par-dessus la couche d'isolant de grille 908, on réalise le dépôt d'une couche 909 de matériau de grille, semi-conducteur par exemple à base de SiGe, ou de polysilicium, ou conducteur par exemple à base de molybdène, ou de TiN.

La couche d'isolant de grille 908 et la couche 909 de matériau de grille sont alors gravées pour former une grille 910. La grille 910 peut être commune à plusieurs canaux, selon que la structure 902a forme un ou plusieurs canaux de transistors.

La figure 9H illustre un dispositif suivant l'invention obtenu après l'étape de formation de la grille précédemment décrite. la structure 902a repose sur la couche isolante 901 recouvrant le substrat 900. Le masque dur 903 a été conservé et recouvre le dessus de la structure 902a. La grille 910 formée de la couche d'isolant de grille 908 et de la couche 909 de matériau semi-conducteur enrobe la structure 902a et le masque dur 903.

Conserver le masque dur 903 sur la structure 902a peut ainsi permettre d'empêcher une conduction parasite entre la grille 910 et le dessus de la structure 902a.

Selon une variante du procédé suivant l'invention, le masque dur 903 peut être retiré préalablement à la formation de la grille 910.

Selon une caractéristique particulière du procédé suivant l'invention, une première zone formant un drain et une seconde zone formant une source, à base de matériau semi-conducteur, peuvent être réalisées après la formation de la structure 902a par implantation ionique de dopants (par exemple : As, Pb, B, BF2) de manière à ce que la structure 902a, relie la source et le drain dans le sens de sa longueur. La structure 902a, forme alors un ou plusieurs canaux de transistors alignés et parallèles entre eux dans un plan orthogonal à un plan principal du substrat.

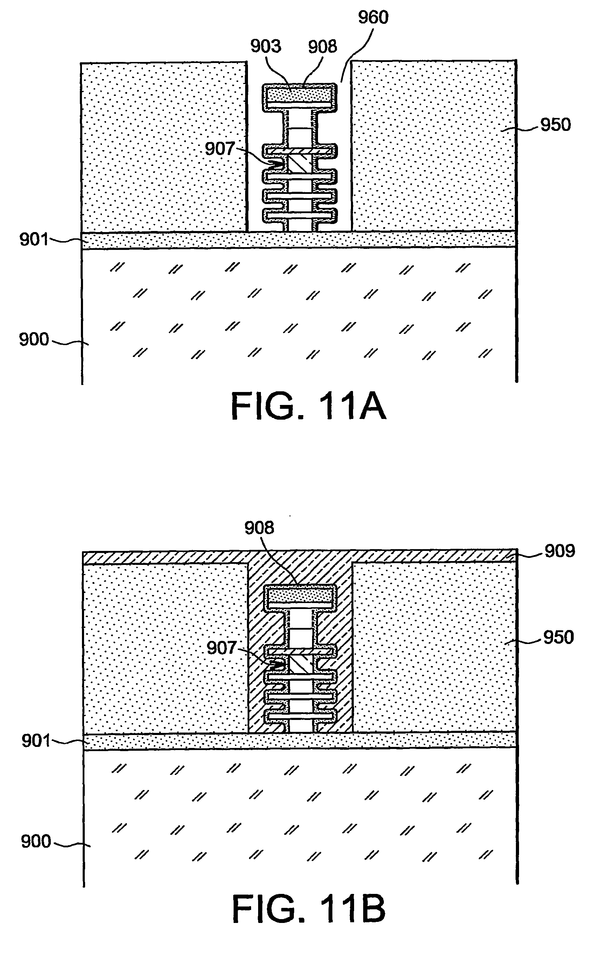

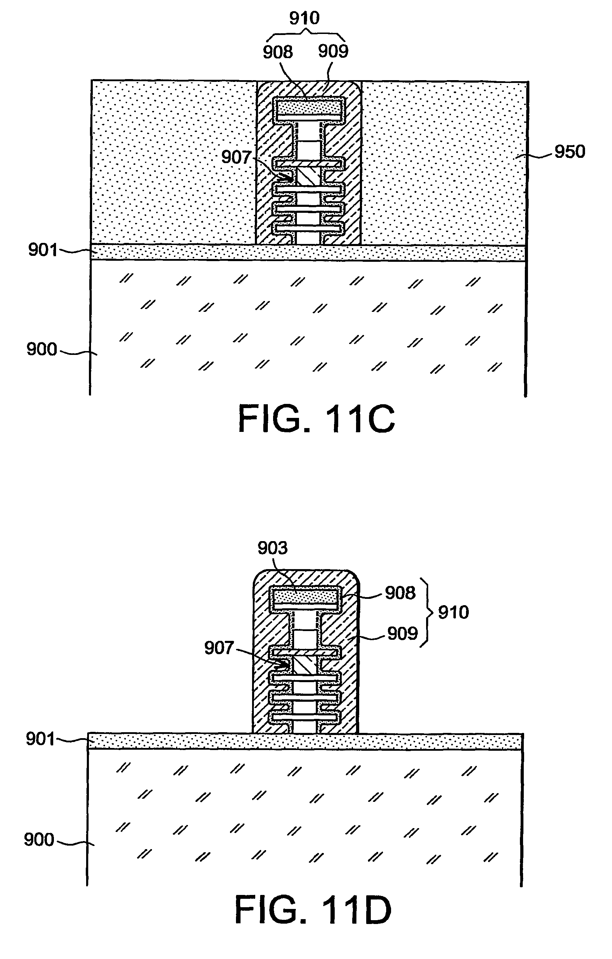

Selon une variante de réalisation, la grille 910 peut être réalisée à l'aide d'un procédé Damascène à partir de la structure 902a. La formation de la grille 910 peut être réalisée tout d'abord par dépôt d'une couche d'isolante 950, par exemple à base d'oxyde HTO (HTO pour « High Temperature Oxide »). La couche isolante 950 peut être réalisée avec une épaisseur supérieure à la hauteur de la structure 902a, de manière à recouvrir cette dernière. On réalise ensuite une ouverture 960 dans la couche isolante 950, de manière à dévoiler la structure 902a. Cette ouverture 960 peut être formée à l'aide d'étapes classiques de photolithographie, suivie d'une gravure de la couche isolante 950. On effectue ensuite un dépôt, qui peut être conforme, d'une couche à base d'isolant de grille 908, par exemple à base de SiO₂, ou de HfO₂, sur la structure 902a (Figure 11A). L'ouverture 960 est ensuite remplie d'un matériau de grille 909, par exemple du polysilicium ou un métal (Figure 11B). Dans le cas où le remplissage de l'ouverture 960 dépasse de l'embouchure de cette dernière et recouvre la couche isolante 950, une étape de CMP (CMP pour « chemical mechanical planarization » ou polissage mécano-chimique) peut être prévue pour ne conserver le matériau de grille 909 que dans l'ouverture 960, jusqu'au niveau de l'embouchure de cette dernière (Figure 11C).

Une étape de retrait de la couche isolante 950 peut ensuite être effectuée (Figure 11D).

### Documents cités

[1] : US patent 5,675,164, « High performance multi-mesa field effect transistor », October 1997, T.A. Brunner et al.
[2] : US patent 6,413,802 B1 « Finfet transistor structures having a double gate channel extending vertically from a substrate and methods of manufacture », July 2002, Hu et al.

## Revendications

1. Dispositif microélectronique à effet de champ comprenant :
a) un substrat (500)
b) une structure (502,602,702,802) formant un ou plusieurs canaux (530, 630a, 630b, 630c, 630d, 630e, 730, 830) aptes à relier, dans le sens de leurs longueurs définies dans une direction parallèle à un plan principal du substrat, au moins une région de source et au moins une région de drain, ladite structure étant bâtie d'un empilement dans une direction orthogonale à un plan principal du substrat formé d'une alternance de barreaux (B₁, B₃, B₅, B₇, B₉) de largeur (s) donnée (s) (W₁, W₃, W₅, W₇, W₉) à base d'un premier matériau semi-conducteur et de barreaux (B₂, B₄, B₆, B₈) de largeur(s) différente(s) de la ou les largeur (s) donnée(s) (W₂, W₄, W₆, W₈) et à base d'un deuxième matériau, le deuxième matériau étant semi-conducteur et différent du premier matériau semi-conducteur ou/et ayant un dopage différent du premier matériau semi-conducteur, ou étant un matériau isolant, l'alternance de barreaux réalisant un profil (503) dentelé.

2. Dispositif microélectronique selon la revendication 1, ledit profil de la structure (602) étant un profil en créneau (603).

3. Dispositif microélectronique selon la revendication 1 ou 2, dans lequel l'empilement est formé d'une alternance de barreaux semi-conducteurs à base de matériaux semi-conducteurs différents, l'empilement comprenant au moins deux barreaux successifs dont un est à base de Si et l'autre est à base de SiGe.

4. Dispositif microélectronique selon l'une des revendications 1 ou 2, dans lequel l'empilement est formé d'une alternance de barreaux semi-conducteurs et de barreaux isolants, l'empilement comprenant au moins deux barreaux successifs dont un est à base de Si et l'autre est à base de SiO₂.

5. Dispositif microélectronique selon l'une des revendications 1 à 4, au moins un des barreaux étant entouré au moins partiellement dans une direction parallèle à un plan principal du substrat de bouchons isolants (706).

6. Dispositif microélectronique selon la revendication 5, lesdits bouchons isolants (706) étant à base de nitrure.

7. Dispositif microélectronique selon l'une des revendications 1 à 6, ladite structure comprenant au moins deux barreaux de longueurs différentes ou/et d'épaisseurs différentes.

8. Dispositif microélectronique selon l'une des revendications 1 à 7, comprenant en outre un masque dur sur ledit empilement.

9. Dispositif microélectronique à effet de champ selon l'une des revendications 1 à 8 comprenant en outre : une grille (650,750) recouvrant au moins partiellement ladite structure (602,702).

10. Procédé de réalisation d'un dispositif microélectronique à effet de champ doté d'au moins une structure (902a) apte à former un ou plusieurs canaux de transistors, la structure comportant des barreaux empilés de largeurs différentes, le procédé comprenant les étapes de :
- formation, sur un substrat (900) d'un empilement (902) de plusieurs couches (C₁,...,Cₙ) comportant une alternance de couches à base d'un premier matériau semi-conducteur, et de couches à base d'un deuxième matériau, semi-conducteur et différent du premier matériau et/ou ayant un dopage différent de celui du premier matériau, ou isolant,
- formation d'au moins un masque sur ledit empilement (902),
- gravure anisotrope des couches à travers le masque,
- gravure partielle et sélective d'une ou plusieurs couches de l'empilement, de manière à former une alternance de barreaux (B₁, B₃, B₅, B₇, B₉) de largeur(s) donnée(s) (W₁, W₃, W₅, W₇, W₉) à base du premier matériau semi-conducteur et de barreaux (B₂, B₄, B₆, B₈) de largeur (s) différente(s) de la ou les largeur(s) donnée(s) (W₂, W₄, W₆, W₈) et à base du deuxième matériau, réalisant un profil dentelé.

11. Procédé selon la revendication 10, dans lequel ledit empilement (902) comporte une alternance de couches à base de matériaux semi-conducteurs différents dont au moins une couche à base de Si et au moins une couche à base de SiGe.

12. Procédé selon la revendication 10, dans lequel ledit empilement (902) comporte une alternance de couches à base de matériau semi-conducteur et de couches à base de matériau isolant, dont au moins une couche à base de Si et au moins une couche à base de SiO₂.

13. Procédé selon l'une des revendications 9 à 12 comprenant en outre : le dépôt conforme d'une couche diélectrique (906) sur ladite structure.

14. Procédé selon la revendication 13, ladite couche diélectrique étant à base de nitrure.

15. Procédé selon l'une des revendications 13 ou 14 comprenant en outre : la gravure isotrope partielle de ladite couche diélectrique de manière à former des bouchons isolants (907) autour de certains barreaux de ladite structure (902a).

16. Procédé selon l'une des revendications 9 à 15 comprenant en outre : la formation d'une grille (910) recouvrant au moins partiellement ladite structure.

17. Procédé selon la revendication 16, la formation de la grille comprenant les étapes consistant à :
- recouvrir la structure d'une couche isolante,
- réaliser au moins une ouverture dans la couche isolante de manière à dévoiler la structure,
- recouvrir la structure d'un isolant de grille,
- remplir l'ouverture d'un matériau de grille.

18. Procédé selon la revendication 16 ou 17, comprenant préalablement à la formation de la grille : une ou plusieurs étapes de dopage de ladite structure (902a).

## Claims

1. Field-effect microelectronic device, including:
a)a substrate (100),
b) a structure (502,602,702,802) forming one or more channels (530, 630a, 630b, 630c 630d, 630e, 730, 830) capable of connecting, in the direction of their lengths defined in a direction parallel to a principal plane of the substrate, at least a source region and at least a drain region, which structure is formed by a stack, in a direction orthogonal to a main plane of the substrate, of an alternation of bars (B₁, B₃, B₅, B₇, B₉) of given width (s) (W₁, W₃, W₅, W₇, W₉) and based on a first semi-conductor material and of bars (B₂, B₄, B₆, B₈) of width (s) (W₂, W₄, W₆, W₈) different from said given width(s) and based on a second material, said second material being semi-conductor material different from said first semi-conductor material and/or having doping different from said first semi-conductor material, or being insulating material, the alternation of bars producing a serrated profile (503).

2. Microelectronic device according to claim 1, said profile of the structure (602) being a crenellated profile (603).

3. Microelectronic device according to one of claims 1 or 2, wherein the stack is formed of an alternation of semi-conductor bars based on different materials, the stack comprising at least two successive bars of which one is based on Si and the other is based on SiGe.

4. Microelectronic device according to one of claims 1 or 2, wherein the stack is formed of an alternation of semiconductor bars and of insulating bars, the stack comprising at least two successive bars of which one is based on Si and the other is based on SiO₂.

5. Microelectronic device according to one of claims 1 to 4, at least one of the bars being at least partially surrounded, in a direction parallel to a main plane of the substrate, with insulating caps (706).

6. Microelectronic device according to claim 5, said insulating caps (706) being based on nitride.

7. Microelectronic device according to one of claims 1 to 6, said structure including at least two bars having different lengths and/or different thicknesses.

8. Microelectronic device according to one of claims 1 to 7, also including a hard mask on said stack.

9. Field-effect microelectronic device according to one of claims 1 to 8, also including : a gate (650,750) at least partially covering said structure and optionally the hard mask (602,702).

10. Method for producing a field-effect microelectronic device equipped with at least one structure (902a) capable of forming one or more transistor channels, said structure comprising at least two stacked bars of different widths, the method including the steps of:
- forming, on a substrate (900), a stack (902) of a plurality of layers (C₁,...,Cₙ) comprising an alternation of layers based on a first semi-conductor material, and layers based on a second material, said second material being semi-conductor material different from said first semi-conductor material and/or having doping different from said first semi-conductor material, or being insulating material,
- forming at least one mask on said stack (902),
- anisotropic etching of the layers through the mask,
- partial and selective etching of one or more layers of the stack, so as to form an alternation of bars (B₁, B₃, B₅, B₇, B₉) of given width (W₁, W₃, W₅, W₇, W₉) and based on the first semi-conductor material and of bars (B₂, B₄, B₆, B₈) of width (W₂, W₄, W₆, W₈) different from said given width and based on the second material, and producing a serrated profile.

11. Method according to claim 10, wherein said stack (902) is formed of an alternation of semi-conductor bars based on different materials, the stack comprising at least two successive bars of which one is based on Si and the other is based on SiGe.

12. Method according to claim 10, wherein said stack (902) is formed of an alternation of semiconductor bars and of insulating bars, the stack comprising at least two successive bars of which one is based on Si and the other is based on SiO₂.

13. Method according to one of claims 9 to 12, also including : the conformal deposition of a dielectric layer on said structure.

14. Method according to claim 13, said dielectric layer being based on nitride.

15. Method according to one of claims 13 or 14, also including : the partial isotropic etching of said dielectric layer, so as to form insulating caps (907) around certain bars of said structure (902a).

16. Method according to one of claims 9 to 15, also including : the formation of a gate at least partially covering said structure.

17. Method according to claim 16, the formation of the gate including steps consisting of:
- covering the structure with an insulating layer,
- forming at least one opening in the insulating layer so as to expose said structure,
- covering the structure with a gate insulating layer,
- filling the opening with a gate material.

18. Method according to one of claims 16 or 17, including, prior to the formation of the gate: one or more steps in which said structure is doped.

## Patentansprüche

1. Mikroelektronische Feldeffekt-Vorrichtung, umfassend
a) ein Substrat (500)
b) eine Struktur (502, 602, 702, 802) zur Bildung eines oder mehrerer Kanäle (530, 630a, 630 b, 630 c, 630 d, 630 e, 730, 830), die jeweils in Richtung ihrer in einer zu einer Hauptebene des Substrats parallelen Richtung definierten Länge wenigstens einen Source-Bereich und wenigstens einen Drain-Bereich verbinden können, wobei die genannte Struktur aus einem Stapel in einer zu einer Hauptebene des Substrats rechtwinkligen Richtung aufgebaut ist, der aus einer Wechselfolge von Stäben bzw. Stangen (B1, B3, B5, B7, B9) von gegebener Breite bzw. Breiten (W 1, W 3, W 5, W 7, W 9) auf der Basis eines ersten Halbleitermaterials und von Stäben bzw. Stangen (B 2, B 4, B 6, B 8) mit von der/den gegebenen Breite(n) verschiedenen Breite bzw. Breiten (W 2, W 4, W 6, W 8) und auf der Basis eines zweiten Materials gebildet wird, wobei das zweite Material ein von dem ersten Halbleitermaterial verschiedener Halbleiter ist und/oder eine von dem ersten Halbleitermaterial verschiedene Dotierung hat oder ein Isolatormaterial ist, derart dass die Wechselfolge von Stäben bzw. Stangen ein gezacktes bzw. gezahntes Profil (503) erhält.

2. Mikroelektronische Vorrichtung nach Anspruch 1, bei welcher die Struktur (602) ein zinnenförmiges Profil (603) ist.

3. Mikroelektronische Vorrichtung nach Anspruch 1 oder 2, bei welcher der Stapel von einer Wechselfolge von Halbleiterstäben auf Basis von unterschiedlichen Halbleitermaterialien gebildet wird, wobei der Stapel wenigstens zwei aufeinander folgende Stäbe bzw. Stangen umfasst, von welchen einer auf Basis von Si und der andere auf Basis von SiGe gebildet ist.

4. Mikroelektronische Vorrichtung nach einem der Ansprüche 1 oder 2, bei welcher der Stapel aus einer Wechselfolge von Halbleiter-Stäben und von Stäben aus isolierendem Material gebildet ist, wobei der Stapel wenigstens zwei aufeinander folgende Stäbe bzw. Stangen umfasst, von welchen einer auf Basis von Si und der andere auf Basis von SiO₂ ausgebildet ist.

5. Mikroelektronische Vorrichtung nach einem der Ansprüche 1 bis 4, wobei wenigstens einer der Stäbe wenigstens teilweise in einer zu einer Hauptebene des Substrats parallelen Richtung von isolierenden Stopfen (706) umgeben ist.

6. Mikroelektronische Vorrichtung nach Anspruch 5, wobei die genannten isolierenden Stopfen (706) auf Nitridbasis ausgebildet sind.

7. Mikroelektronische Vorrichtung nach einem der Ansprüche 1 bis 6, bei welcher die genannte Struktur wenigstens zwei Stäbe unterschiedlicher Länge und/oder unterschiedlicher Dicke umfasst.

8. Mikroelektronische Vorrichtung nach einem der Ansprüche 1 bis 7, welche des Weiteren eine harte Maske auf dem genannten Stapel umfasst.

9. Mikroelektronische Feldeffekt-Vorrichtung nach einem der Ansprüche 1 bis 8, welche des Weiteren ein die genannte Struktur (602, 702) wenigstens teilweise überdeckendes Gitter (650, 750) umfasst.

10. Verfahren zur Herstellung einer mikroelektronischen Feldeffekt-Vorrichtung mit wenigstens einer Struktur (902 a), die einen oder mehrere Transistorkanal bzw.
- kanäle bilden kann, wobei die Struktur gestapelte Stäbe bzw. Stangen unterschiedlicher Breite bilden kann, und wobei das Verfahren die folgenden Stufen bzw. Schritte umfasst:
- - auf einem Substrat (900) wird ein Stapel (902) von mehreren Schichten (C1, ......, Cn) ausgebildet, welcher eine Wechselfolge von Schichten auf Basis eines ersten Halbleitermaterials und von Schichten auf Basis eines zweiten Materials umfasst, das ein von dem ersten Material verschiedener Halbleiter ist und/oder ein Halbleiter mit von der Dotierung des ersten Materials verschiedener Dotierung ist, oder ein Isolatormaterial ist,
- - Ausbilden wenigstens einer Maske auf dem genannten Stapel (902),
- - anisotrope Ätzung der Schichten durch die Maske hindurch,
- - partielle und selektives Ätzen einer oder mehrerer Schichten des Stapels, derart dass eine Wechselfolge von Stäben bzw. Stangen (B1, B3, B5, B7, B9) von gegebener Breite bzw. Breiten (W1, W3, W5, W7, W9) auf Basis des ersten Halbleitermaterials und von Stäben bzw. Stangen (B2, B4, B6, B8) mit von der bzw. den gegebenen Breite(n) jeweils verschiedener Breite bzw. Breiten (W2, W4, W6, W8) und auf Basis des zweiten Materials gebildet wird, unter Bildung eines gezahnten bzw. gezackten Profiles.

11. Verfahren nach Anspruch 10, bei welchem der Stapel (902) eine Werchselfolge von Schichten auf Basis unterschiedlicher Halbleitermaterialien umfasst, darunter wenigstens eine Schicht auf Basis von Si und wenigstens eine Schicht auf Basis von SiGe.

12. Verfahren nach Anspruch 10, bei welchem der Stapel (902) eine Wechselfolge von Schichten auf Basis von Halbleitermaterial und von Schichten auf Basis von Isolatormaterial umfasst, darunter wenigstens eine Schicht auf Si-Basis und wenigstens eine Schicht auf SiO₂-Basis.

13. Verfahren nach einem der Ansprüche 9 bis 12, welches des Weiteren die konforme Abscheidung einer dielektrischen Schicht (906) auf der Struktur umfasst.

14. Verfahren nach Anspruch 13, bei welchem die dielektrische Schicht auf Nitrid-Basis ausgebildet ist.

15. Verfahren nach einem der Ansprüche 13 oder 14, umfassend des Weiteren die isotrope partielle Ätzung der dielektrischen Schicht derart, dass isolierende Stopfen (907) um bestimmte Stäbe bzw. Stangen der Struktur (902) herum gebildet werden.

16. Verfahren nach einem der Ansprüche 9 bis 15, umfassend des Weiteren die Bildung eines die Struktur wenigstens teilweise überdeckenden Gitters (910).

17. Verfahren nach Anspruch 16, bei welchem die Bildung des Gitters die folgenden Schritte bzw. Stufen umfasst:
- - Abdecken bzw. Überziehen der Struktur mit einer Isolierschicht
- - Herstellen wenigstens einer Öffnung in der Isolierschicht, um die Struktur freizulegen
- - Abdecken bzw. Überziehen der Struktur mit einem Gitter-Isoliermaterial,
- - Ausfüllen der Öffnung mit einem Gittermaterial.

18. Verfahren nach Anspruch 16 oder 17, welches vor der Ausbildung des Gitters einen oder mehrere Schritte der Dotierung der Struktur umfasst.
